# EUROPÄISCHE PATENTANMELDUNG

(11) **EP 4 163 828 A1**
(43) Veröffentlichungstag der Anmeldung: **12.04.2023**
(21) Anmeldenummer: 22194901.9
(22) Anmeldetag: 09.09.2022
(51) Int. Cl.: G06N 3/02, G06F 30/13, G06F 30/27, G06N 3/045

(54) **VERFAHREN ZUM UNTERSTÜTZEN EINER ENTWICKLUNG EINER VORRICHTUNG, INSBESONDERE FÜR EIN FAHRZEUG, COMPUTERPROGRAMMPRODUKT SOWIE ENTWICKLUNGSSYSTEM**

(30) Priorität: 08.10.2021 DE 102021211356
(71) Anmelder: VOLKSWAGEN AG, 38440 Wolfsburg (DE)
(72) Erfinder: Schöning, Volkmar, 30900 Wedemark (DE); Hüsemann, Frank, 38162 Cremlingen (DE)

(57) **Zusammenfassung**

Die Erfindung betrifft ein Verfahren (100) zum Unterstützen einer Entwicklung einer Vorrichtung (1) durch einen Entwicklungsprozess (200) in einem Entwicklungssystem (2) mit zumindest einer Entwicklungsebene (10), die zumindest ein künstliches, neuronales erstes Netzwerk (11), welches durch einen ersten Datensatz (211) Trainingsdaten trainiert ist, und ein künstliches, neuronales zweites Netzwerk (12), welches durch einen zweiten Datensatz (212) Trainingsdaten trainiert ist, aufweist, und einer Evaluationsebene (20) mit zumindest einem neuronalen Evaluationsnetzwerk (21) zum Evaluieren von Entwicklungsergebnissen der Entwicklungsebene (10). Ferner betrifft die Erfindung ein Computerprogrammprodukt, sowie ein Entwicklungssystem (2).

## Beschreibung

Die Erfindung betrifft ein Verfahren zum Unterstützen einer Entwicklung einer Vorrichtung, insbesondere für ein Fahrzeug, ein Computerprogrammprodukt sowie ein Entwicklungssystem zum Unterstützen einer Entwicklung einer Vorrichtung.

Es ist aus dem Stand der Technik bekannt, zur Bewältigung großer Datenmengen künstliche neuronale Netzwerke einzusetzen. Gerade bei ursprünglich kreativen Prozessen, sind die Ergebnisse jedoch häufig stark von den Trainingsdaten sowie der, zum Teil zufälligen, Ausprägung der Gewichtungen der künstlichen Netzwerke abhängig. Daher ist es beispielsweise aus der US 2021/0174130 A1 bekannt, mehrere künstliche Netzwerke einzusetzen, welche die gleiche Aufgabe lösen. Anschließend wird auf Basis der vorgeschlagenen Lösungen eine Entscheidung getroffen.

Insbesondere in Serienfertigungen mit vielen Individualisierungen, wie z.B. im Automobilbau, ist es jedoch häufig wünschenswert, verschiedene Interessen in einer Vorrichtung, wie beispielsweise einer Fahrzeugkomponente, zu vereinen, um die Vorrichtung als Gleichteil für unterschiedliche Fahrzeugmodelle und/oder Fahrzeugkonfigurationen nutzen zu können.

Es ist eine Aufgabe der vorliegenden Erfindung, voranstehende, aus dem Stand der Technik bekannte Nachteile zumindest teilweise zu beheben. Insbesondere ist es eine Aufgabe der vorliegenden Erfindung Unterstützung einer Entwicklung einer Vorrichtung zu verbessern.

Die voranstehende Aufgabe wird gelöst durch ein Verfahren mit den Merkmalen des Anspruchs 1, ein Computerprogrammprodukt mit den Merkmalen des Anspruchs 9, sowie ein Entwicklungssystem mit den Merkmalen des Anspruchs 10. Weitere Merkmale und Details der Erfindung ergeben sich aus den jeweiligen Unteransprüchen, der Beschreibung und den Zeichnungen. Dabei gelten Merkmale und Details, die im Zusammenhang mit dem erfindungsgemäßen Verfahren beschrieben sind, selbstverständlich auch im Zusammenhang mit dem erfindungsgemäßen Computerprogrammprodukt und/oder dem erfindungsgemäßen Entwicklungssystem und jeweils umgekehrt, so dass bezüglich der Offenbarung zu den einzelnen Erfindungsaspekten stets wechselseitig Bezug genommen wird bzw. werden kann.

Gemäß einem ersten Aspekt der Erfindung ist ein Verfahren zum Unterstützen einer Entwicklung einer Vorrichtung vorgesehen. Das Unterstützen der Entwicklung der Vorrichtung erfolgt zumindest durch einen Entwicklungsprozess in einem Entwicklungssystem, das zumindest eine Entwicklungsebene umfasst. Die Entwicklungsebene weist zumindest ein künstliches, neuronales erstes Netzwerk auf, welches durch einen ersten Datensatz Trainingsdaten trainiert ist, und ein künstliches, neuronales zweites Netzwerk, welches durch einen zweiten Datensatz Trainingsdaten trainiert ist. Weiterhin umfasst das Entwicklungssystem eine Evaluationsebene mit zumindest einem künstlichen, neuronalen Evaluationsnetzwerk zum Evaluieren von Entwicklungsergebnissen der Entwicklungsebene. Zum Durchführen des Entwicklungsprozesses werden folgende Schritte ausgeführt:
- Erhalt von Eingangsdaten für ein Entwicklungsziel durch das erste Netzwerk und durch das zweite Netzwerk,
- Bestimmen von ersten Ergebnisdaten eines ersten Entwicklungsergebnisses in Abhängigkeit von den Eingangsdaten durch das erste Netzwerk und von zweiten Ergebnisdaten eines zweiten Entwicklungsergebnisses in Abhängigkeit von den Eingangsdaten durch das zweite Netzwerk,
- Bewerten der ersten Ergebnisdaten und der zweiten Ergebnisdaten durch das Evaluationsnetzwerk in Abhängigkeit von zumindest einem vorgegebenen Auswertekriterium,
- Ausgabe von Dokumentationsdaten zu den ersten Ergebnisdaten und den zweiten Ergebnisdaten durch das Evaluationsnetzwerk, insbesondere in Abhängigkeit von dem Bewerten der ersten Ergebnisdaten und der zweiten Ergebnisdaten.

Bei der Vorrichtung kann es sich vorzugsweise um ein Fahrzeug oder eine Fahrzeugkomponente handeln. Die Entwicklung der Vorrichtung kann vollständig oder zumindest teilweise durch den Entwicklungsprozess erfolgen.

Bei der Entwicklungsebene und der Evaluationsebene handelt es sich insbesondere um Datenstrukturen, welche die jeweiligen künstlichen, neuronalen Netzwerke aufweisen. Vorzugsweise umfasst die Entwicklungsebene weitere künstliche, neuronale Netzwerke, die durch weitere Datensätze Trainingsdaten trainiert sind. Ferner kann das Evaluationsnetzwerk vorteilhafterweise mehrere Evaluationsnetzwerke zum Bewerten von Ergebnisdaten von Netzwerken der Evaluationsebene umfassen.

Durch das erste Netzwerk, das zweite Netzwerk und das Evaluationsnetzwerk kann insbesondere eine künstliche Intelligenz zur Unterstützung der Entwicklung bereitgestellt werden. Der erste Datensatz von Trainingsdaten und der zweite Datensatz von Trainingsdaten umfassen vorzugsweise jeweils Datensammlungen, die das erste und zweite Netzwerk befähigen, die Vorrichtung oder einen Teil der Vorrichtung zu entwerfen. Ferner ist es denkbar, dass der erste und zweite Datensatz Trainingsdaten das jeweilige neuronale Netzwerk dazu befähigt, technische, wie z.B. Maße, Werkstoffe, Formen und/oder dergleichen, in Abhängigkeit von den Eingangsdaten und/oder dem Entwicklungsziel auszugeben.

Der erste und zweite Datensatz der Trainingsdaten können sich beispielsweise inhaltlich oder in einer Klassifizierungsvorgabe unterscheiden. Vorzugsweise umfassen die Trainingsdaten Entwicklungsdaten, wie z.B. technische Zeichnungen, Stücklisten, Werkstoffe und/oder Festigkeitsberechnungen, einer Entwicklungshistorie für die Vorrichtung. Beispielsweise können die Trainingsdaten Entwicklungsdaten früherer Fahrzeugmodelle umfassen. Dabei kann der erste Datensatz Trainingsdaten, durch welchen das erste Netzwerk trainiert ist, beispielsweise Entwicklungsdaten von Sportwagen und der zweite Datensatz Trainingsdaten, durch welchen das zweite Netzwerk trainiert ist, Entwicklungsdaten von Kleinwagen umfassen. Es ist jedoch ebenso denkbar, dass der erste und zweite Datensatz Trainingsdaten inhaltlich die gleichen Dokumente umfassen und sich in der Klassifizierungsvorgabe unterscheiden. Wenn die Entwicklungsdaten beispielsweise verwendete Motoren umfassen, die für ein Training des ersten und zweiten Netzwerkes durch eine Klassifizierungsvorgabe klassifiziert sind, kann die Klassifizierungsvorgabe für den ersten Datensatz Trainingsdaten andere Motoren priorisieren, als die Klassifizierungsvorgabe für den zweiten Datensatz Trainingsdaten.

Das Entwicklungsziel kann insbesondere durch die Eingangsdaten definiert sein. Dabei können die Eingangsdaten Rahmenvorgaben für das Entwicklungsziel umfassen. Beispielsweise können die Rahmenvorgaben Merkmale der Vorrichtung, wie z.B. eine vorgegebene Mindestanzahl an Schnittstellen und/oder Maße eines maximalen Bauraums, umfassen.

Die ersten und zweiten Ergebnisdaten können vom ersten und zweiten Netzwerk direkt an das Evaluationsnetzwerk übertragen werden. Es ist jedoch ebenso denkbar, dass die ersten und zweiten Ergebnisdaten zunächst weiterverarbeitet werden, bevor das Bewerten der ersten und zweiten Ergebnisdaten durch das Evaluationsnetzwerk erfolgt. Beim Bewerten kann beispielsweise eine Klassifizierung der Ergebnisdaten in Abhängigkeit von dem Auswertekriterium erfolgen. Das Auswertekriterium kann beispielsweise eine Quantifizierung und/oder Klassifizierung der durch die ersten und/oder zweiten Ergebnisdaten umgesetzten Randbedingungen umfassen. Durch das Bewerten der Ergebnisdaten können die Entwicklungsergebnisse somit evaluiert werden.

Die Ausgabe der Dokumentationsdaten kann vorzugsweise in menschenlesbarer und/oder maschinenlesbarer Form erfolgen. Insbesondere können die Dokumentationsdaten die ersten und/oder zweiten Ergebnisdaten in menschenlesbarer Form umfassen. Vorzugsweise umfassen die Dokumentationsdaten Bewertungsdaten des Bewertens der ersten und zweiten Ergebnisdaten. Beispielsweise können die Bewertungsdaten durch das Evaluationsnetzwerk in Form eines Netzdiagrammes menschenlesbar aufbereitet und/oder zusammengefasst werden.

Durch das erste und zweite Netzwerk können somit unterschiedliche Entwicklungsergebnisse erzielt werden, deren Ergebnisdaten durch das Evaluationsnetzwerk automatisch bewertet werden können. Dadurch können automatisiert beispielsweise mehrere Durchläufe des Entwicklungsprozesses, beispielsweise mit unterschiedlichen Eingangsdaten, durchgeführt werden. Insbesondere können durch die Verwendung von zwei oder mehr künstlichen, neuronalen Netzwerken der Entwicklungsebene konkurrierende Entwicklungsergebnisse erstellt werden, von denen das beste Entwicklungsergebnis für die Umsetzung der Vorrichtung ausgewählt werden kann. Ferner kann vorgesehen sein, dass die übrigen Entwicklungsergebnisse z.B. zur Umsetzung eines anderen, kostengünstigeren Modells der Vorrichtung verwendet werden.

Weiterhin ist es bei einem erfindungsgemäßen Verfahren denkbar, dass die Eingangsdaten Ressourcenvorgaben zur Nutzung von Ressourcen durch das erste Netzwerk und das zweite Netzwerk für das Bestimmen der ersten und zweiten Ergebnisdaten, insbesondere zum Erreichen des Entwicklungsziels, umfassen. Durch die Ressourcenvorgaben kann dem ersten und zweiten Netzwerk somit insbesondere mitgeteilt werden, welche Ressourcen das jeweilige Netzwerk zum Bestimmen der jeweiligen Ergebnisdaten nutzen darf. Beispielsweise können die Ressourcenvorgaben eine vorgegebene, insbesondere maximale, Rechenzeit, eine vorgegebene, insbesondere maximal nutzbare, Rechenleistung und/oder vorgegebene Meilensteine zum Erreichen des Entwicklungsziels umfassen. Durch die Ressourcenvorgaben kann sichergestellt werden, dass das erste und zweite Netzwerk die Entwicklungsergebnisse unter den gleichen Voraussetzungen erzeugen. Dadurch sind die Entwicklungsergebnisse beim Bewerten der ersten und zweiten Ergebnisdaten besser vergleichbar. Weiterhin kann dadurch beispielsweise eine Rückkopplung zum Weitertrainieren des ersten und/oder zweiten Netzwerkes verbessert sein.

Vorzugsweise kann bei einem erfindungsgemäßen Verfahren vorgesehen sein, dass das Entwicklungssystem eine Standardisierungsebene mit zumindest einem künstlichen, neuronalen Standardisierungsnetzwerk aufweist, durch welches vor dem Bewerten der ersten Ergebnisdaten und der zweiten Ergebnisdaten ein Erkennen von Überschneidungen der ersten Ergebnisdaten und der zweiten Ergebnisdaten erfolgt. Das Erkennen der Überschneidungen kann vorteilhafterweise durch einen Vergleich der ersten und zweiten Ergebnisdaten erfolgen. Bei der Standardisierungsebene handelt es sich insbesondere um eine Datenstruktur, welche das Standardisierungsnetzwerk aufweist. Die Überschneidungen können beispielsweise gleiche Zwischenergebnisse und/oder Gleichteile der Vorrichtung umfassen. Es kann vorgesehen sein, dass Unterschiede in den Ergebnisdaten durch das Standardisierungsnetzwerk extrahiert und/oder separiert werden. Somit können die Ergebnisdaten vorteilhafterweise durch die Standardisierungsebene für die Evaluationsebene aufbereitet werden. Dadurch kann das Bewerten der Ergebnisdaten vereinfacht sein. Vorzugsweise umfasst die Standardisierungsebene mehrere Standardisierungsnetzwerke.

Ferner kann bei einem erfindungsgemäßen Verfahren vorteilhafterweise vorgesehen sein, dass durch das Standardisierungsnetzwerk eine Ausgabe von Zwischendokumentationsdaten zur Dokumentation der Überschneidungen erfolgt. Die Zwischendokumentationsdaten können die Überschneidungen und/oder die Unterschiede der ersten und zweiten Ergebnisdaten umfassen. Die Zwischendokumentationsdaten können vorzugsweise menschenlesbar und/oder maschinenlesbar ausgegeben werden. Beispielsweise können die Zwischendokumentationsdaten Funktionsdaten für jedes der Entwicklungsergebnisse umfassen. Insbesondere können die Zwischendokumentationsdaten baukastenartig strukturiert sein. Dadurch können die Zwischendokumentationsdaten für eine spätere Einsichtnahme und/oder für die darauffolgenden Verfahrensschritte, insbesondere als Modulhandbuch, für die Ergebnisdaten bereitgestellt werden.

Im Rahmen der Erfindung ist es weiterhin denkbar, dass das Entwicklungssystem eine Entscheidungsebene mit einem Entscheidungsmodul aufweist, durch welches anhand der Bewertung der ersten Ergebnisdaten und der zweiten Ergebnisdaten Entscheidungsdaten ausgegeben werden. Durch die zusätzliche Entscheidungsebene kann eine vorlagefähige Entscheidung getroffen und ausgegeben werden, welches der Entwicklungsergebnisse zu priorisieren ist. Die Entscheidungsdaten können beispielsweise Informationen über Kosten, Termine, Integrität und/oder technischer Spezifikationen, insbesondere des priorisierten Entwicklungsergebnisses, umfassen. Vorzugsweise können die Entscheidungsdaten durch das Entscheidungsmodul in Form eines Abschlussberichtes in menschenlesbarer und/oder maschinenlesbarer Form ausgegeben werden. Das Entscheidungsmodul kann eine Hardwarekomponente und/oder eine Softwarekomponente umfassen. Vorzugsweise ist das Entscheidungsmodul als künstliches, neuronales Netzwerk ausgebildet. Es ist denkbar, dass das Entscheidungsmodul zum Erzeugen und Ausgeben der Entscheidungsdaten anhand vorbestimmter Kriterien ausgebildet ist. Bei der Standardisierungsebene kann es sich insbesondere um eine Datenstruktur, welche das Entscheidungsmodul aufweist, handeln.

Es ist ferner bei einem erfindungsgemäßen Verfahren denkbar, dass Erstdokumentationsdaten jeweils durch das erste Netzwerk in Abhängigkeit von den ersten Ergebnisdaten und durch das zweite Netzwerk in Abhängigkeit von den zweiten Ergebnisdaten ausgegeben werden. Die Erstdokumentationsdaten können insbesondere zu einer besseren Nachvollziehbarkeit des Entwicklungsprozesses ausgegeben werden. Vorzugsweise werden die Erstdokumentationsdaten in maschinenlesbarer und/oder menschenlesbarer Form ausgegeben. Es kann vorgesehen sein, dass die Ergebnisdaten durch die Entwicklungsebene, insbesondere durch das erste und/oder zweite Netzwerk, aufbereitet werden, um die Erstdokumentationsdaten zu erstellen. Beispielsweise können die Erstdokumentationsdaten eine Dokumentation, vorzugsweise in Form eines UML-Diagrammes, der Entwicklungsergebnisse für jedes der Netzwerke der Entwicklungsebene umfassen.

Vorzugsweise kann bei einem erfindungsgemäßen Verfahren vorgesehen sein, dass das Verfahren folgenden Schritt umfasst:
- Weitertrainieren des ersten Netzwerkes und/oder des zweiten Netzwerkes in Abhängigkeit von dem Bewerten der ersten Ergebnisdaten und der zweiten Ergebnisdaten durch das Evaluationsnetzwerk.
Durch das Weitertrainieren des ersten Netzwerkes und/oder des zweiten Netzwerkes kann eine Rückkopplung aus der Evaluationsebene zur Entwicklungsebene erfolgen, wodurch das erste und/oder zweite Netzwerk für spätere Entwicklungsprozesse aus dem Bewerten der ersten und zweiten Ergebnisdaten lernen können. Zusätzlich oder alternativ kann ein Weitertrainieren des ersten Netzwerkes und/oder des zweiten Netzwerkes in Abhängigkeit von den Entscheidungsdaten der Entscheidungsebene und/oder den Überschneidungen erfolgen. Weiterhin ist es denkbar, dass das Evaluationsnetzwerk in Abhängigkeit von den Entscheidungsdaten weitertrainiert wird. Somit kann sich das Entwicklungssystem mit jedem Entwicklungsprozess automatisch selbst weiter verbessern.

Im Rahmen der Erfindung ist es weiterhin denkbar, dass zum Unterstützen der Entwicklung der Vorrichtung ferner zumindest ein Vorentwicklungsprozess durch zumindest ein weiteres Entwicklungssystem, vorzugsweise zum Durchführen eines weiteren Entwicklungsprozesses in Form des Vorentwicklungsprozesses, durchgeführt wird, wobei künstliche, neuronale weitere Netzwerke des weiteren Entwicklungssystems beim Vorentwicklungsprozess durch weitere Datensätze Trainingsdaten zum Unterstützen der Entwicklung zukünftiger Entwicklungsziele trainiert sind. Zum Durchführen des Vorentwicklungsprozesses können durch das weitere Entwicklungssystem die gleichen Schritte ausgeführt werden, die für den Entwicklungsprozess ausgeführt werden, wobei dem weiteren Entwicklungssystem beispielsweise andere Eingangsdaten und/oder andere Trainingsdaten zugrunde gelegt werden können. Vorzugsweise können mehrere Vorentwicklungsprozesse mit unterschiedlichen Zeithorizonten, beispielsweise zum Entwickeln der Vorrichtung in 5, 15 oder mehr Jahren, ausgeführt werden. Es ist denkbar, dass die weiteren Netzwerke des weiteren Entwicklungssystems für den Vorentwicklungsprozess durch öffentlich zugängliche Daten, wie z.B. Veröffentlichungen in Zeitschriften, im Internet und/oder dergleichen, trainiert sind und/oder kontinuierlich weitertrainiert werden. Der Vorentwicklungsprozess ist insbesondere dem Entwicklungsprozess vorgeschaltet. Durch den Vorentwicklungsprozess kann somit eine Vorentwicklung der Vorrichtung durch ein oder mehrere weitere Entwicklungsnetzwerke erfolgen. Dadurch können beispielsweise taktische und/oder strategische Vorgaben für die Entwicklung der Vorrichtung frühzeitig erstellt werden. Es ist denkbar, dass die Eingangsdaten des Entwicklungsprozesses durch den Vorentwicklungsprozess zumindest teilweise oder vollständig bereitgestellt werden.

Gemäß einem weiteren Aspekt der Erfindung ist ein Computerprogrammprodukt vorgesehen. Das Computerprogrammprodukt umfasst Befehle, die bei einer Ausführung durch eine Recheneinheit die Recheneinheit veranlassen, ein erfindungsgemäßes Verfahren auszuführen.

Somit bringt ein erfindungsgemäßes Computerprogrammprodukt die gleichen Vorteile mit sich, wie sie bereits ausführlich mit Bezug auf ein erfindungsgemäßes Verfahren beschrieben worden sind. Bei dem Verfahren kann es sich insbesondere um ein computerimplementiertes Verfahren handeln. Das Computerprogrammprodukt kann als computerlesbarer Anweisungscode implementiert sein. Ferner kann das Computerprogrammprodukt auf einem computerlesbaren Speichermedium wie einer Datendisk, einem Wechsellaufwerk, einem flüchtigen oder nichtflüchtigen Speicher, oder einem eingebauten Speicher/Prozessor abgespeichert sein. Ferner kann das Computerprogrammprodukt in einem Netzwerk, wie beispielsweise dem Internet bereitstellbar oder bereitgestellt sein, von dem es bei Bedarf von einem Nutzer heruntergeladen werden kann. Das Computerprogrammprodukt kann sowohl mittels einer Software, als auch mittels einer oder mehrerer spezieller elektronischer Schaltungen, d.h. in Hardware oder in beliebig hybrider Form, d.h. mittels Software-Komponenten und Hardware-Komponenten, realisiert sein.

Gemäß einem weiteren Aspekt der Erfindung ist ein Entwicklungssystem zum Unterstützen einer Entwicklung einer Vorrichtung durch einen Entwicklungsprozess vorgesehen. Das Entwicklungssystem weist zumindest eine Recheneinheit zum Ausführen eines erfindungsgemäßen Verfahrens auf.

Somit bringt ein erfindungsgemäßes Entwicklungssystem die gleichen Vorteile mit sich, wie sie bereits ausführlich mit Bezug auf ein erfindungsgemäßes Verfahren und/oder ein erfindungsgemäßes Computerprogrammprodukt beschrieben worden sind. Bei dem Entwicklungssystem handelt es sich insbesondere um ein Rechensystem mit einer oder mehreren Rechnerarchitekturen. Insbesondere umfasst das Entwicklungssystem einen oder mehrere Rechenprozessoren. Beispielsweise kann das Entwicklungssystem zumindest teilweise oder vollständig in einen Server und/oder ein Rechenzentrum integriert sein. Weiterhin ist es denkbar, dass es sich bei dem Entwicklungssystem um ein verteiltes System handelt, welches beispielsweise als Cloud vernetzt ist.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen schematisch:
- Figur 1: ein erfindungsgemäßes Entwicklungssystem zum Ausführen eines erfindungsgemäßen Verfahrens zum Unterstützen einer Entwicklung einer Vorrichtung,
- Figur 2: Verfahrensschritte des Verfahrens,
- Figur 3: eine Visualisierung von Dokumentationsdaten zu Ergebnisdaten des Verfahrens, und
- Figur 4: mehrere Entwicklungssysteme zur Durchführung eines Entwicklungsprozesses und mehrerer Vorentwicklungsprozesse.

In der nachfolgenden Beschreibung zu einigen Ausführungsbeispielen der Erfindung werden für die gleichen technischen Merkmale auch in unterschiedlichen Ausführungsbeispielen die identischen Bezugszeichen verwendet.

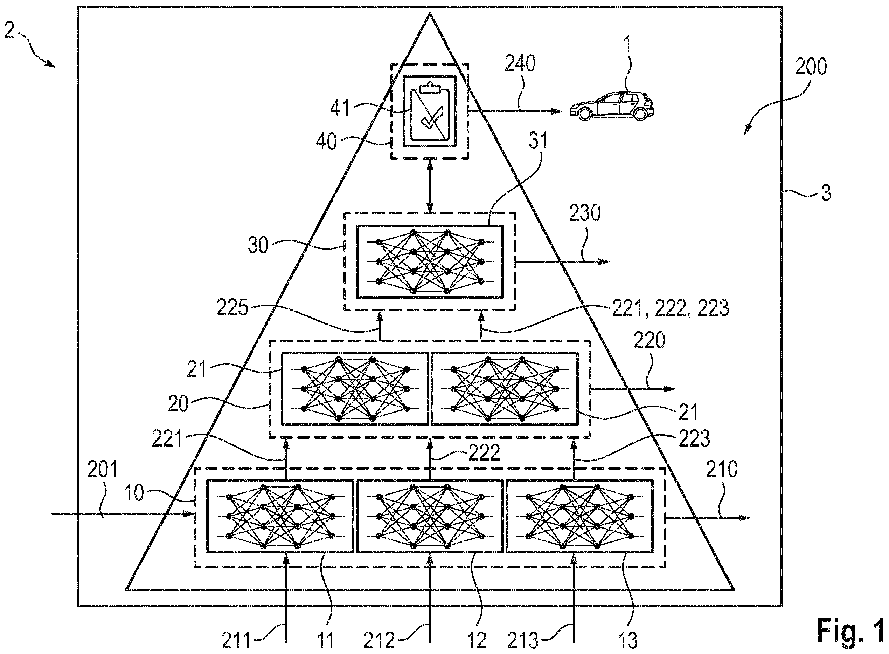

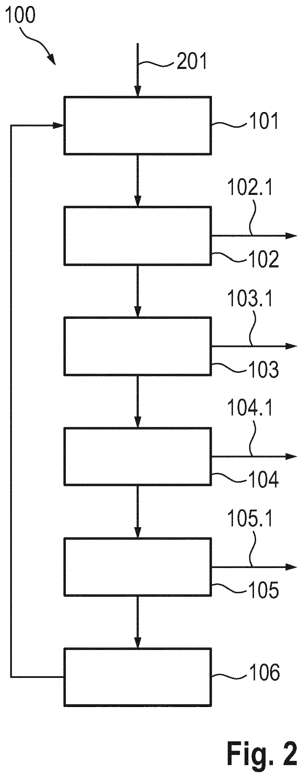

Figur 1 zeigt ein Entwicklungssystem 2 zum Unterstützen einer Entwicklung einer Vorrichtung 1 durch einen Entwicklungsprozess 200. Bei der Vorrichtung 1 kann es sich vorzugsweise um ein Fahrzeug oder eine Fahrzeugkomponente handeln. Das Entwicklungssystem 2 umfasst eine Recheneinheit 3 zum Ausführen eines erfindungsgemäßen Verfahrens 100 zum Unterstützen der Entwicklung der Vorrichtung 1 durch den Entwicklungsprozess 200. Eine Abfolge von Verfahrensschritten des Verfahrens 100 ist in Figur 2 dargestellt. Vorzugsweise ist ein erfindungsgemäßes Computerprogrammprodukt vorgesehen, das Befehle umfasst, die bei einer Ausführung durch die Recheneinheit 3 die Recheneinheit 3 veranlassen, das Verfahren 100 auszuführen.

Das Entwicklungssystem 2 umfasst eine Entwicklungsebene 10 mit einem künstlichen, neuronalen, ersten Netzwerk 11, einem künstlichen neuronalen zweiten Netzwerk 12 und einem oder mehreren künstlichen neuronalen weiteren Netzwerken 13. Es ist jedoch ebenso denkbar, dass die Entwicklungsebene 10 nur das erste Netzwerk 11 und das zweite Netzwerk 12 umfasst.

Das erste Netzwerk 11 ist durch einen ersten Datensatz 211, das zweite Netzwerk 12 durch einen zweiten Datensatz 212 und das weitere Netzwerk 13 durch einen weiteren Datensatz 213 trainiert. Dabei unterscheiden sich die Datensätze 211, 212, 213 voneinander, so dass die Netzwerke 11, 12, 13 der Entwicklungsebene 10, insbesondere bei gleichen Eingangsdaten 201, unterschiedliche Entwicklungsergebnisse erzeugen. Vorzugsweise umfassen die Trainingsdaten Entwicklungsdaten, wie z.B. technische Zeichnungen, Stücklisten, Werkstoffe und/oder Festigkeitsberechnungen, einer Entwicklungshistorie für die Vorrichtung 1.

Zum Durchführen des Entwicklungsprozesses 200 erfolgt im Rahmen des Verfahrens 100 ein Erhalt 101 von Eingangsdaten 201 für ein Entwicklungsziel durch das erste Netzwerk 11, das zweite Netzwerk 12 und das dritte Netzwerk 13. Die Eingangsdaten 201 Rahmenvorgaben für das Entwicklungsziel und/oder Ressourcenvorgaben zur Nutzung von Ressourcen durch die Netzwerke 11, 12, 13 für das Bestimmen 102 von Ergebnisdaten 221, 222, 223 umfassen. Beispielsweise können durch die Eingangsdaten 201 Mindestvoraussetzungen für die Vorrichtung 1 im Rahmen des Entwicklungsziels und eine maximale, durch die Netzwerke 11, 12, 13 genutzte Rechenzeit zum Erreichen des Entwicklungsziels umfassen. In Abhängigkeit von den Eingangsdaten 201 erfolgt ein Bestimmen 102 von ersten Ergebnisdaten 221 eines ersten Entwicklungsergebnisses durch das erste Netzwerk 11, von zweiten Ergebnisdaten 222 eines zweiten Entwicklungsergebnisses durch das zweite Netzwerk 12 und von weiteren Ergebnisdaten 223 eines weiteren Entwicklungsergebnisses durch das weitere Netzwerk 13.

Vorteilhafterweise kann das Verfahren 100 jeweils eine Ausgabe 102.1 von menschenlesbaren Erstdokumentationsdaten 210 durch das erste Netzwerk 11 in Abhängigkeit von den ersten Ergebnisdaten 221, durch das zweite Netzwerk 12 in Abhängigkeit von dem weiteren Ergebnisdaten 223 und durch das weitere Netzwerk 13 in Abhängigkeit von den weiteren Ergebnisdaten 223, um die Entwicklungsergebnisse zu einem späteren Zeitpunkt nachvollziehen zu können.

Weiterhin weist das Entwicklungssystem 2 insbesondere eine Standardisierungsebene 30 mit zumindest einem künstlichen, neuronalen Standardisierungsnetzwerk 31 auf. Wie in Figur 1 dargestellt, können vorzugsweise mehrere Standardisierungsnetzwerke 31 vorgesehen sein. Durch das zumindest eine Standardisierungsnetzwerk 31 erfolgt vor dem Bewerten 104 der ersten Ergebnisdaten 221, der zweiten Ergebnisdaten 222 und der weiteren Ergebnisdaten 223 ein Erkennen 103 von Überschneidungen 225 der ersten Ergebnisdaten 221, der zweiten Ergebnisdaten 222 und der weiteren Ergebnisdaten 223 und eine Ausgabe 103.1 von vorzugsweise menschenlesbaren Zwischendokumentationsdaten 220 zur Dokumentation der Überschneidungen 225. Dadurch können auch nach Abschluss des Entwicklungsprozesses 200 Zwischenergebnisse eingesehen werden, wobei durch die Dokumentation der Überschneidungen 225 besonders interessante Lösungen schnell aufgefunden werden können.

Weiterhin umfasst das Verfahren 100 auf Basis der durch das Standardisierungsnetzwerk 31 aufbereiteten Ergebnisdaten 221, 222, 223 ein Bewerten 104 der ersten Ergebnisdaten 221, der zweiten Ergebnisdaten 222 und der weiteren Ergebnisdaten 223 durch zumindest ein künstliches, neuronales Evaluationsnetzwerk 21 in Abhängigkeit von vorgegebenen Auswertekriterien 224. Dazu weist das Entwicklungssystem 2 eine Evaluationsebene 20 mit dem Evaluationsnetzwerk 21 auf.

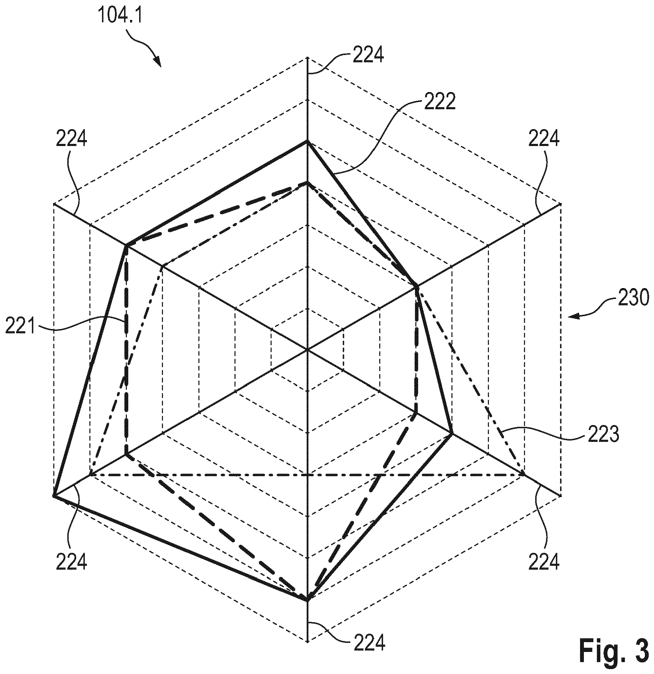

Anschließend erfolgt eine Ausgabe 104.1 von Dokumentationsdaten 230 zu den ersten Ergebnisdaten 221, den zweiten Ergebnisdaten 222 und zu den weiteren Ergebnisdaten 223 durch das Evaluationsnetzwerk 21. Beispielsweise kann die Ausgabe 104.1 der Dokumentationsdaten 230 eine Visualisierung der Ergebnisdaten 221, 222, 223, insbesondere wie in Figur 3 dargestellt umfassen. So kann beim Bewerten 104 der Ergebnisdaten 221, 222, 223 eine Klassifizierung anhand vorgegebener Auswertekriterien erfolgen, die in der Visualisierung dargestellt ist. Die Auswertekriterien 224 können qualitative Kriterien, wie z. B. eine Sportlichkeit und/oder ein Komfort umfassen. Es ist jedoch ebenso denkbar, dass die Auswertekriterien quantitative Kriterien, wie z. B. eine Anzahl Schnittstellen und/oder Kosten, umfassen.

Anhand der Bewertung 104 durch das Evaluationsnetzwerk 21 erfolgt ein Erzeugen 105 von Entscheidungsdaten 240 und eine Ausgabe 105.1 der Entscheidungsdaten 240 durch ein Entscheidungsmodul 41. Das Entscheidungsmodul 41 bildet eine Entscheidungsebene 40 des Entwicklungssystems 2, um anhand der Bewertung 104 eine vorlagefähige Entwicklungsentscheidung zur Realisierung, zum Testen und/oder zur Produktion der Vorrichtung 1 treffen zu können.

In Abhängigkeit von der Bewertung 104 durch das Evaluationsnetzwerk 21 und/oder von den Entscheidungsdaten 240 des Entscheidungsmoduls 41 erfolgt ferner ein Weitertrainieren 106 der Netzwerke 11, 12, 13 der Entwicklungsebene 10 durch eine Rückkopplung. Dadurch kann das Entwicklungssystem 2 kontinuierlich verbessert werden.

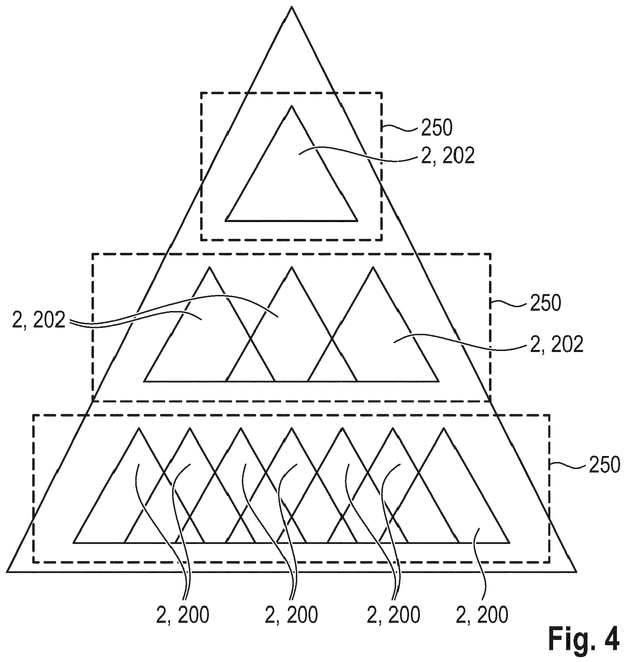

Figur 4 zeigt ferner mehrere Entwicklungssysteme 2 zur Durchführung des Entwicklungsprozesses 200 und mehrerer weiterer Entwicklungsprozesse in Form von Vorentwicklungsprozessen 202. Die Vorentwicklungsprozesse 202 können analog zum Entwicklungsprozess 200 durchgeführt werden, wobei die weiteren Entwicklungssystem 2 zum Durchführen der Vorentwicklungsprozesse 202 künstlichen, neuronale weitere Netzwerke aufweisen, die durch weitere Datensätze Trainingsdaten zum Unterstützen der Entwicklung zukünftiger Entwicklungsziele trainiert sind. Dazu können die Vorentwicklungsprozesse 202 mit unterschiedlichen Zeithorizonten, beispielsweise zum Entwickeln der Vorrichtung 1 in 5, 15 oder mehr Jahren, ausgeführt werden. Vorzugsweise finden mehrere Entwicklungsprozesse 200 gleichzeitig statt, wobei mit zunehmendem Zeithorizont, insbesondere aufgrund der unsicheren, in die Zukunft gerichteten Entwicklung, weniger Vorentwicklungsprozesse 202 vorgesehen sind.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

### Bezugszeichenliste

- 1: Vorrichtung
- 2: Entwicklungssystem
- 3: Recheneinheit

- 10: Entwicklungsebene
- 11: erstes Netzwerk
- 12: zweites Netzwerk
- 13: weitere Netzwerke

- 20: Evaluationsebene
- 21: Evaluationsnetzwerk

- 30: Standardisierungsebene
- 31: Standardisierungsnetzwerk

- 40: Entscheidungsebene
- 41: Entscheidungsmodul

- 100: Verfahren
- 101: Erhalt
- 102: Bestimmen von 221
- 102.1: Ausgabe von 210
- 103: Erkennen von 225
- 103.1: Ausgabe von 220
- 104: Bewerten von 221, 222, 223
- 104.1: Ausgabe von 230
- 105: Erzeugen von 105
- 105.1: Ausgabe von 240
- 106: Weitertrainieren von 11, 12, 13

- 200: Entwicklungsprozess
- 201: Eingangsdaten
- 202: Vorentwicklungsprozess

- 210: Erstdokumentationsdaten
- 211: erster Datensatz Trainingsdaten
- 212: zweiter Datensatz Trainingsdaten
- 213: weitere Datensätze Trainingsdaten

- 220: Zwischendokumentationsdaten
- 221: erste Ergebnisdaten
- 222: zweite Ergebnisdaten
- 223: weitere Ergebnisdaten
- 224: Auswertekriterium
- 225: Überschneidungen

- 230: Dokumentationsdaten

- 240: Entscheidungsdaten

- 250: Zeithorizonte

## Patentansprüche

1. Verfahren (100) zum Unterstützen einer Entwicklung einer Vorrichtung (1) durch einen Entwicklungsprozess (200) in einem Entwicklungssystem (2) mit zumindest einer Entwicklungsebene (10), die zumindest ein künstliches, neuronales erstes Netzwerk (11), welches durch einen ersten Datensatz (211) Trainingsdaten trainiert ist, und ein künstliches, neuronales zweites Netzwerk (12), welches durch einen zweiten Datensatz (212) Trainingsdaten trainiert ist, aufweist, und einer Evaluationsebene (20) mit zumindest einem künstlichen, neuronalen Evaluationsnetzwerk (21) zum Evaluieren von Entwicklungsergebnissen der Entwicklungsebene (10),
wobei zum Durchführen des Entwicklungsprozesses (200) folgende Schritte ausgeführt werden:
- Erhalt (101) von Eingangsdaten (201) für ein Entwicklungsziel durch das erste Netzwerk (11) und durch das zweite Netzwerk (12),
- Bestimmen (102) von ersten Ergebnisdaten (221) eines ersten Entwicklungsergebnisses in Abhängigkeit von den Eingangsdaten (201) durch das erste Netzwerk (11) und von zweiten Ergebnisdaten (222) eines zweiten Entwicklungsergebnisses in Abhängigkeit von den Eingangsdaten (201) durch das zweite Netzwerk (12),
- Bewerten (104) der ersten Ergebnisdaten (221) und der zweiten Ergebnisdaten (222) durch das Evaluationsnetzwerk (21) in Abhängigkeit von zumindest einem vorgegebenen Auswertekriterium (224),
- Ausgabe (104.1) von Dokumentationsdaten (230) zu den ersten Ergebnisdaten (221) und den zweiten Ergebnisdaten (222) durch das Evaluationsnetzwerk (21).

2. Verfahren (100) nach Anspruch 1,
**dadurch gekennzeichnet,**
**dass** die Eingangsdaten (201) Ressourcenvorgaben zur Nutzung von Ressourcen durch das erste Netzwerk (11) und das zweite Netzwerk (12) für das Bestimmen (102) der ersten Ergebnisdaten (221) und zweiten Ergebnisdaten (222) umfassen.

3. Verfahren (100) nach einem der vorhergehenden Ansprüche,
**dadurch gekennzeichnet,**
**dass** das Entwicklungssystem (2) eine Standardisierungsebene (30) mit zumindest einem künstlichen, neuronalen Standardisierungsnetzwerk (31) aufweist, durch welches vordem Bewerten (104) der ersten Ergebnisdaten (221) und der zweiten Ergebnisdaten (222) ein Erkennen (103) von Überschneidungen (225) der ersten Ergebnisdaten (221) und der zweiten Ergebnisdaten (222) erfolgt.

4. Verfahren (100) nach einem der vorhergehenden Ansprüche,
**dadurch gekennzeichnet,**
**dass** durch das Standardisierungsnetzwerk (31) eine Ausgabe (103.1) von Zwischendokumentationsdaten (220) zur Dokumentation der Überschneidungen (225) erfolgt.

5. Verfahren (100) nach einem der vorhergehenden Ansprüche,
**dadurch gekennzeichnet,**
**dass** das Entwicklungssystem (2) eine Entscheidungsebene (40) mit einem Entscheidungsmodul (41) aufweist, durch welches anhand der Bewertung der ersten Ergebnisdaten (221) und der zweiten Ergebnisdaten (222) Entscheidungsdaten (240) ausgegeben werden.

6. Verfahren (100) nach einem der vorhergehenden Ansprüche,
**dadurch gekennzeichnet,**
**dass** Erstdokumentationsdaten (210) jeweils durch das erste Netzwerk (11) in Abhängigkeit von den ersten Ergebnisdaten (221) und durch das zweite Netzwerk (12) in Abhängigkeit von den zweiten Ergebnisdaten (222) ausgegeben werden.

7. Verfahren (100) nach einem der vorhergehenden Ansprüche,
**dadurch gekennzeichnet,**
**dass** das Verfahren (100) folgenden Schritt umfasst:
- Weitertrainieren (106) des ersten Netzwerkes (11) und/oder des zweiten Netzwerkes (12) in Abhängigkeit von dem Bewerten der ersten Ergebnisdaten (221) und der zweiten Ergebnisdaten (222) durch das Evaluationsnetzwerk (21).

8. Verfahren (100) nach einem der vorhergehenden Ansprüche,
**dadurch gekennzeichnet,**
**dass** zum Unterstützen der Entwicklung der Vorrichtung (1) ferner zumindest ein Vorentwicklungsprozess (202) durch zumindest ein weiteres Entwicklungssystem (2) zum Durchführen eines weiteren Entwicklungsprozesses (200) in Form des Vorentwicklungsprozesses (202) durchgeführt wird, wobei künstliche, neuronale weitere Netzwerke des weiteren Entwicklungssystems (2) beim Vorentwicklungsprozess (202) durch weitere Datensätze Trainingsdaten zum Unterstützen der Entwicklung zukünftiger Entwicklungsziele trainiert sind.

9. Computerprogrammprodukt, umfassend Befehle, die bei einer Ausführung durch eine Recheneinheit (3) die Recheneinheit (3) veranlassen, ein Verfahren (100) nach einem der vorhergehenden Ansprüche auszuführen.

10. Entwicklungssystem (2) zum Unterstützen einer Entwicklung einer Vorrichtung (1) durch einen Entwicklungsprozess (200) aufweisend
zumindest eine Recheneinheit (3) zum Ausführen eines Verfahrens (100) nach einem der Ansprüche 1 bis 8.
